# EUROPEAN PATENT APPLICATION

(11) **EP 1 818 426 A2**
(43) Date of publication of application: **15.08.2007**
(21) Application number: 07109393.4
(22) Date of filing: 18.10.2005
(51) Int. Cl.: C23C 30/00

(54) **Coated inserts for dry milling**

(30) Priority: 08.11.2004 SE 0402709
(62) Divisional of application: 05445077.0
(71) Applicant: Sandvik Intellectual Property AB, 811 81 Sandviken (SE)
(72) Inventor: Hessman, Ingemar, SE 811 54 Sandviken (SE)
(74) Representative: Hägglöf, Henrik

(57) **Abstract**

The present invention discloses coated milling inserts particularly useful for milling of grey cast iron with or without cast skin under dry conditions at preferably rather high cutting speeds and milling of nodular cast iron and compacted graphite iron with or without cast skin under dry conditions at rather high cutting speeds.

The inserts are characterised by a WC-Co cemented carbide with a low content of cubic carbides and a highly W-alloyed binder phase and a coating including an inner layer of TiCₓN_{y} with columnar grains followed by a wet blasted layer of α-Al₂O₃.

## Description

The present invention relates to coated cemented carbide cutting tool inserts, particularly useful for rough milling of highly alloyed grey cast iron, nodular cast iron and compacted graphite iron with or without cast skin under dry conditions, preferably at rather high cutting speeds.

US 6,638,609 discloses coated milling inserts particularly useful for milling of grey cast iron with or without cast skin under wet conditions at low and moderate cutting speeds and milling of nodular cast iron and compacted graphite iron with or without cast skin under wet conditions at moderate cutting speeds. The inserts are characterised by a WC-Co cemented carbide with a low content of cubic carbides and a highly W-alloyed binder phase and a coating including an inner layer of TiCₓN_{y} with columnar grains followed by a layer of κ-Al₂O₃ and a top layer of TiN.

It is an object of the present invention to provide coated cemented carbide cutting tool inserts, particularly useful for rough milling under dry conditions of highly alloyed grey cast iron, nodular cast iron and compacted graphite iron under dry conditions, preferably at rather high cutting speeds.

It has now surprisingly been found that cutting tool inserts showing improved properties with respect to the different wear types prevailing at the above mentioned cutting operations can be obtained with cutting tool inserts comprising: a cemented carbide body with a relatively high W-alloyed binder phase and with a well balanced chemical composition and grain size of the WC, a columnar TiCₓN_{y}-layer and a wet blasted α-Al₂O₃-layer.

According to the present invention coated cutting tool inserts are provided consisting of a cemented carbide body with a composition of 7.3-7.9 wt-% Co, preferably 7.6 wt-% Co, 1.0-1.8 wt-%, preferably 1.4-1.7 wt-%, cubic carbides of the metals Ta and Nb and balance WC. The average grain size of the WC is in the range of about 1.5-2.5 µm, preferably about 1.8 µm.

The cobalt binder phase is rather highly alloyed with W. The content of W in the binder phase can be expressed as the CW-ratio= M_{S} / (wt-% Co 0.0161), where M_{S} is the saturation magnetization of the cemented carbide body in kA/m and wt-% Co is the weight percentage of Co in the cemented carbide. The CW-value is a function of the W content in the Co binder phase. A high CW-value corresponds to a low W-content in the binder phase.

It has now been found according to the present invention that improved cutting performance is achieved if the cemented carbide body has a CW-ratio of 0.86-0.94. The cemented carbide may contain small amounts, <3 vol-%, of η-phase, M₆C, without any detrimental effect.

The radius of the uncoated cutting edge is 35-60 µm.

The coating comprises
- a first, innermost layer of TiCₓN_{y}O_{z} with x+y+z=1, y>x and z<0.2, preferably y>0.8 and z=0, with equiaxed grains with size <0.5 µm and a total thickness <1.5 µm preferably >0.1 µm,
- a layer of TiCₓN_{y} with x+y=1, x>0.3 and y>0.3, preferably x>0.5, with a thickness of 4.5-9.5 µm, preferably 5-8 µm, with columnar grains and with an average diameter of <5 µm, preferably 0.1-2 µm,
- a layer of a smooth, fine-grained, average grain size about 0.5-2 µm, Al₂O₃ consisting essentially of the α-phase. However, the layer may contain small amounts, <5 vol-%, of other phases such as θ- or κ-phase as determined by XRD-measurement. The Al₂O₃-layer has a thickness of 4.5-9.5 µm, preferably 5-8 µm with a surface roughness of preferably Rₘₐₓ≤0.4 µm over a length of 10 µm.

The present invention also relates to a method of making coated cutting tool inserts consisting of a cemented carbide body with a composition of 7.3-7.9 wt-% Co, preferably 7.6 wt-% Co, 1.0-1.8 wt-%, preferably 1.4-1.7 wt-% cubic carbides of the metals Ta and Nb and balance WC. The average grain size of the WC is in the range of about 1.5-2.5 µm, preferably about 1.8 µm.

The cobalt binder phase is rather highly alloyed with W to a CW-ratio of 0.86-0.94 defined as above. The cemented carbide may contain small amounts, <3 vol-%, of η-phase, M₆C, without any detrimental effect.

The inserts are dry blasted to 35-60 µm edge honing and after that a coating is deposited comprising
- a first, innermost layer of TiCₓN_{y}O_{z} with x+y+z=1, y>x and z<0.2, preferably y>0.8 and z=0, with equiaxed grains with size <0.5 µm and a total thickness <1.5 µm preferably >0.1 µm, using known CVD-methods
- a layer of TiCₓN_{y} with x+y=1, x>0.3 and y>0.3, preferably x>0.5, with a thickness of 4.5-9.5 µm, preferably 5-8 µm, with columnar grains and with an average diameter of <5 µm, preferably 0.1-2 µm using preferably MTCVD-technique using acetonitrile as the carbon and nitrogen source for forming the layer in the temperature range of 700-900 °C. The exact conditions, however, depend to a certain extent on the design of the equipment used,
- a layer of a smooth, fine-grained, average grain size about 0.5-2 µm, Al₂O₃ consisting essentially of the α-phase using known CVD-methods. However, the layer may contain small amounts, <5 vol-% of other phases such as θ- or κ-phase as determined by XRD-measurement. The Al₂O₃-layer has a thickness of 4.5-9.5 µm, preferably 5-8 µm.
- Finally the inserts are dry blasted with alumina grit in order to obtain smooth surface finish, preferably a surface roughness Rₘₐₓ≤0.4 µm over a length of 10 µm.

The invention also relates to the use of cutting tool inserts according to above for rough milling under dry conditions of highly alloyed grey cast iron, compacted graphite iron and nodular iron with or without cast skin, at a cutting speed of 100-300 m/min and a feed of 0.15-0.35 mm/tooth depending on cutting speed and insert geometry.

### Example 1

A. Cemented carbide milling inserts in accordance with the invention with the composition 7.6 wt-% Co, 1.25 wt-% TaC, 0.30 wt-% NbC and balance WC with average grain size of 1.8 µm, with a binder phase alloyed with W corresponding to a CW-ratio of 0.87 were coated with a 0.5 µm equiaxed TiC_{0.05}N_{0.95}-layer with a high nitrogen content corresponding to an estimated C/N-ratio of 0.05 followed by an 11 µm thick TiC_{0.54}N_{0.46}-layer, with columnar grains by using MTCVD-technique (temperature 850-885 °C and CH₃CN as the carbon/nitrogen source). In subsequent steps during the same coating cycle, a 4 µm thick layer of α-Al₂O₃ was deposited using a temperature 970 °C and a concentration of H₂S dopant of 0.4 % as disclosed in EP-A-523 021.

The inserts were dry blasted with alumina grit in order to obtain a smooth surface finish.

### Example 2

Inserts according to the present invention were tested in a face milling of cylinder block in highly alloyed grey cast iron
Tool: Sandvik Coromant R260.31-250
Number of inserts: 40 PCs
Criterion: Surface finish and work piece frittering.
Reference: TNEF 1204AN-CA in grade Sandvik Coromant GC3020
A: Competitor grade
B: Competitor grade
Cutting data
Cutting speed: Vc = 120 m/min
Feed per tooth: Fz= 0.2 mm per tooth
Depth of cut: Ap=4 mm
Dry conditions

Tool life of the reference GC3020 (prior art) 1000 engine blocks in production.

Tool life of invention 2073 cylinder heads, average of five tests.

Increase of tool life 107 % with improved surface finish and productivity.

Tool life of competitor A 1187 PCs.

Tool life of competitor B 1205 PCs.

### Example 3

Inserts according to the present invention were tested in a face milling of cylinder heads in highly alloyed grey cast iron
Tool: Sandvik Coromant R260.31-315
Number of inserts: 50 PCs
Criteria: Surface finish and work piece frittering.
Reference TNEF 1204AN-WL in grade Sandvik Coromant GC3040
Cutting data
Cutting speed: Vc = 283 m/min
Feed per tooth: Fz= 0.27 mm per tooth
Depth of cut: Ap=3-5 mm
Dry conditions

Tool life reference 3040 75 cylinder heads in standard production.

Tool life of invention 231 cylinder heads, average of five tests

Increase of tool life 208 % with improved surface finish.

## Claims

1. A cutting tool insert for milling of highly alloyed grey cast iron with or without cast skin under dry conditions at preferably rather high cutting speeds and in low and moderate cutting speeds and milling of nodular cast iron and compacted graphite iron under dry conditions at moderate cutting speeds comprising a cemented carbide body and a coating
**characterized in that** said cemented carbide body has an uncoated cutting edge radius of 35-60 µm and comprises WC with an average grain size of 1.5-2.5 µm, 7.3-7.9 wt-% Co and 1.0-1.8 wt-% cubic carbides of metals Ta and Nb, with <3 vol-% eta-phase and **in that** said coating comprises
- a first, innermost layer of TiCₓN_{y}O_{z} with x+y+z=1, y>x and z<0. 2, preferably y>0.8 and z=0, with equiaxed grains with size <0.5 µm and a total thickness of 0.1-1.5 µm,
- a layer of TiCₓN_{y} with x+y=1, x>0.3 and y>0.3, preferably x>0.5, with a thickness of 4.5-9.5 µm with columnar grains with an average diameter of <5 µm,
- a layer of a smooth, fine-grained, 0.5-2 µm α-Al₂O₃ with a thickness of 4.5-9.5 µm preferably with a surface roughness of Rₘₐₓ≤0.4 µm over a length of 10 µm.

2. Milling insert according to claim 1
**characterized in that** the cemented carbide contains 1.4-1.7 wt-% carbides of Ta and Nb.

3. Method of making a milling insert comprising a cemented carbide body and a coating **characterised in that** the WC-Co-based cemented carbide body comprises WC, 7.3-7.9 wt-% Co and 1.0-1.8 wt-% cubic carbides of Ta and Nb and a highly W-alloyed binder phase, the method comprising the steps of:
- dry blasting the inserts to 35-60 µm edge honing before coating,
- depositing by a CVD-method a first, innermost layer of TICₓN_{y}O_{z} with x+y+z=1, y>x and z<0.2 having an equiaxed grain structure with a size <0.5 µm and a total thickness of 0.1-1.5 µm,
- depositing by a MTCVD-technique a layer of TiCₓN_{y} with x+y=1, x>0.3 and y>0.3 with a thickness of 4.5-9.5 µm having a columnar grain structure with an average diameter of <5 µm, wherein the MTCVD-technique uses acetonitrile as a source of carbon and nitrogen for forming a layer in a temperature range of 700-900°C,
depositing a layer of α-Al₂O₃ with a thickness of 4.5-9.5 µm using known CVD-methods and
dry blasting said layer with alumina grit in order to obtain smooth surface finish, preferably with a surface roughness of Rₘₐₓ≤0.4 µm over a length of 10 µm.

4. Method according to the previous claim
**characterized in that** said cemented carbide body contains 1.4-1.7 wt-% carbides of Ta and Nb.

5. Use of a cutting tool insert according to claims 1-2 for dry milling of highly alloyed grey cast iron, compacted graphite iron and nodular iron at a cutting speed of 100-300 m/min and a feed of 0.15-0.35 mm/tooth depending on cutting speed and insert geometry.
